# EUROPEAN PATENT APPLICATION

(11) **EP 0 792 756 A2**
(43) Date of publication of application: **03.09.1997**
(21) Application number: 97103075.4
(22) Date of filing: 26.02.1997
(51) Int. Cl.: B41M 5/36

(54) **Liquid composition laser marking article and marking process**

(30) Priority: 28.02.1996 JP 65182/96
(71) Applicant: NIPPON KAYAKU KABUSHIKI KAISHA, Tokyo 102 (JP)
(72) Inventor: Hayashihara, Shoiti, Yono-shi (JP); Nishitoh, Mitsuyo, Yokohama-shi (JP); Shinmoto, Masaki, Yono-shi (JP)
(74) Representative: Türk, Gille, Hrabal, Leifert

(57) **Abstract**

This invention relates to a liquid composition comprising an energy beam-curable resin, a leuco dye and a developer and has a viscosity of not more than 20 cps as measured by an E type viscometer at 60°C, a laser marking article having a cured film of the liquid composition, a process for producing a laser marking article, characterized by coating the liquid composition on the surface of an article by a spray coating method and then irradiating the coated article with an energy beam except laser, and a laser marking process characterized by irradiating the cured film layer formed on an article with a laser beam. According to this invention, there is obtained an energy beam-curable, liquid composition for laser marking suitable for spray coating and gravure printing without using a solvent or dispersing agent, and the cured film of this liquid composition has little Discoloration of the ground, a good adhesiveness to substrate, and when it is irradiated with a laser beam, the portion irradiated develops a vivid black color which is excellent in fastness.

## Description

### BACKGROUND OF THE INVENTION

### Field of the Invention

This invention relates to a liquid composition for imparting a vivid black mark to the surface of an article by irradiation with laser beams, said composition being suitable for a spary coating; a laser marking article, a process for producing the laser marking article; and a laser marking process using the liquid composition.

### Related Art

In marking the surfaces of electronic parts such as IC, resistor, condenser, inductor and the like; electrical parts such as relay, switch, connector, printed circuit board and the like; housings of electrical device; automobile parts; machine parts; cables; sheets; packaging sheets; cards; various containers for foods, medicines and the like; caps of the containers; labels; and the like, with letters and symbols such as maker's name, article name, production date, lot number and the like, there have recently been popularly used a printing method using a marking ink and a marking method using an ink jet. However, these methods have such problems that it takes a long period of time in the course of from printing to drying of ink, the marking of the fine parts is difficult, the maintenance and control of print quality are complicated, the cost is high and environmental pollution is caused owing to use of solvent. Therefore, the rationalization of the methods has been desired.

For the rationalization of the marking method, recently, a laser marking method has become carried out in which the surfaces of parts or the like are directly irradiated with laser beams to etch a part of the surfaces by heat decomposition or evaporation, thereby marking the surfaces. However, in the above marking method, the parts to be marked are made of various kinds of materials, and hence, there are such problems that vivid marking is impossible with some materials or when the parts are made of colored materials vivid marks are difficult to obtain.

As a method for solving the above-mentioned problems, there has been known a method which comprises coating the surface of an article to be marked such as electronic and electrical parts, housings, packages and the like with a laser-markable, energy beam-curable resin, curing the resin and thereafter etching the resin with laser beams to mark the article. This method has such advantages that it can be carried out in a short time, can mark fine articles and can provide good markings. However, said method has such a disadvantage that when some marking materials are used, the marks obtained are vanished by oils attached thereto or the like. In addition, in the case of an ink which develops a color, particular a black color, by a laser, a compound containing a heavy metal such as lead or the like has heretofore been used as a coloring matter. However, there have been such problems that the environment is polluted with the heavy metal and the mark is not vivid. For development of a black color without using a heavy metal which causes environmental pollution, there has been taken into consideration a system using a developer and a leuco dye which is used in a heat-sensitive recording material; however, there is such a disadvantage that when the leuco dye and the developer are applied onto an energy beam-curable resin, a color appears gradually even when the resin has not been irradiated with laser beams (this is called "Discoloration of the ground"). For solving this problem, the present inventors have found that the use of a leuco dye whose solubility in toluene at 25°C is 5 w/v % or less is effective, and have applied for a patent (WO 96/00262).

On the other hand, an ink for a laser marking method using an energy beam-curable resin is usually coated by such a method as pad printing, offset printing or screen printing and the viscosity required therefor is usually in a high viscosity range of from several thousands cps to several tens of thousands of cps as measured by an E type viscometer in order to impart thereto printability and adhesiveness to substrate. However, in the case of printing or coating an article which is produced at a very high speed, such an application method as spray coating or gravure printing is favorable. However, the viscosity required therefor is generally not more than 50 cps as measured by an E type viscometer, and when an energy beam-curable resin capable of giving such a low viscosity is used, there is such a problem that Discoloration of the ground tends to be caused and the adhesion to a substrate, particularly a metal is lowered. Moreover, it is tried to make the viscosity low by diluting with a solvent the ink to be used in the pad printing, offset printing or screen printing; however, in this case, there is such a problem that an additional step of evaporating the solvent is required and the environment is polluted by diffusion of the solvent into the air.

### SUMMARY OF THE INVENTION

The present inventors have made extensive research for solving the above problems to reach this invention.

An object of this invention is to develop a liquid marking composition which is free from solvent, excellent in spray coatability and gravure printability, little in Discoloration of the ground and also excellent in adhesiveness to substrate, heat resistance, water resistance, resistance to moist heat and color-developability.

Another object of this invention is to provide a laser marking article.

A still another object of this invention is to provide a laser marking process using the above liquid marking composition.

Other objects and advantages of this invention will become apparent of the following description.

According to this invention, there are provided:
(1) a liquid composition which comprises an energy beam-curable resin, a leuco dye and a developer and has a viscosity of not more than 20 cps as measured by an E type viscometer at 60°C;
(2) the liquid composition of (1) wherein the energy beam-curable resin is a resin having no proton-emitability,
(3) the liquid composition of (2) wherein the resin having no proton-emitability is composed of an acrylate type resin having a cyclic structure in the molecule and another energy-beam curable resin and the viscosity of one of the resins or the viscosities of both the resins are not more than 50 cps as measured by an E type viscometer at 25°C,
(4) the liquid composition of (3) wherein the acrylate type resin having a cyclic structure in the molecule is an acrylate type resin having a cycloaliphatic group,
(5) the liquid composition of (4) wherein the acrylate type resin having a cycloaliphatic group is an acrylate type resin having a dicyclopentanyl ring or an isobornyl ring,
(6) the liquid composition of (4) wherein the acrylate type resin having a cycloaliphatic group is dicyclopentanyl acrylate or isobornyl acrylate,
(7) the liquid composition of (3) wherein the content of the acrylate resin having a cyclic structure in the molecule is 50 to 95% by weight in the resin having no proton-emitability,
(8) the liquid composition of (1) wherein the leuco dye is a fluoran compound represented by the formula (1): 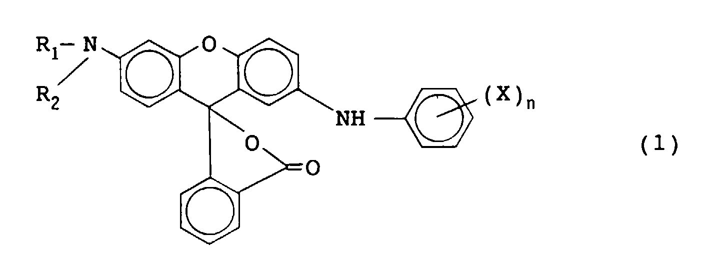 wherein each of R₁ and R₂ represents an alkyl group having 1 to 4 carbon atoms, X represents a halogen atom and n represents an integer of 1 or 2 and wherein when n is 2 the two X groups may be the same as or different from each other, or 2,2-bis(4-(6'-(N-cyclohexyl-N-methylamino)-3'-methylspiro(phthalido-3,9'-xanthene)-2'-ylamino)phenyl)propane,
(9) the liquid composition of (1) wherein the developer is a bisphenol A type developer, a biphenol type developer, a bisphenol S type developer or a sulfonylphenol type developer,
(10) the liquid composition of (1) wherein the developer is at least one member selected from the group consisting of 4,4'-isopropylidenediphenol, 1,1-bis(p-hydroxyphenyl)cyclohexane, 4,4'-dihydroxybiphenyl, 4,4'-sulfonyldiphenol, 2,2'-diallyl-4,4'-sulfonyldiphenol and 4-(4'-isopropoxyphenyl)sulfonylphenol,
(11) a laser marking article which has a cured film of the liquid composition of (1) on its surface,
(12) the laser marking article of (11) wherein the article is a bottle, a cap, a card, a label or a can,
(13) the laser marking article of (11) wherein the material of the article is aluminum,
(14) the laser marking article of (11) wherein the thickness of the cured film is 3 to 50 µm,
(15) a process for producing a laser marking article, which comprises coating an article with the liquid composition of (1) by a spray coating method and then irradiating the coated article with an energy beam except laser,
(16) the process for producing a laser marking article of (15) wherein the energy beam is an ultraviolet ray or an electron beam,
(17) a laser marking process which comprises irradiating a cured film layer formed on the surface of an article with a laser beam,
(18) the laser marking process of (17) wherein the laser is an infrared ray laser,
(19) the laser marking process of (18) wherein the infrared ray laser is a far infrared ray laser, and
(20) the laser marking process of (17) wherein the energy density in the portion irradiated with a laser beam is 0.5 to 6 J/cm².

### DETAILED DESCRIPTION OF THE INVENTION

The liquid composition of this invention comprises an energy beam-curable resin, a leuco dye and a developer and has a viscosity of not more than 20 cps as measured by an E type viscometer at 60°C. This liquid composition is particularly suitable for use in a spray coating.

The energy beam-curable resin used in this invention is a resin curable with an energy beam such as an infrared ray, a visible light, an ultraviolet ray, an electron beam or the like, preferably a resin curable with an ultraviolet ray or an electron beam, and includes radical polymerization type resins and cationic polymerization type resins. The radical polymerization type reins are preferred. The above energy-beam curable resin may be any resin alone or in admixture of two or more as far as the resin or resins, when mixed with the leuco dye and the developer, give a viscosity of not more than 20 cps as measured by an E type viscometer at 60°C and does not dissolve the leuco dye. However, a resin which has no proton-emitability is preferred in view of coloration of the liquid composition with time. Moreover, the energy beam-curable resin is preferably a mixed resin of an acrylate type resin having a cyclic structure in the molecule (preferably a monoacrylate type resin) and at least one other energy beam-curable resin, the viscosity of one of the resins or the viscosities of both the resins being not more than 50 cps as measured by an E type viscometer at 25°C in view of the adhesiveness to substrate. The mixing proportion is such that the former is 50 to 95% by weight and the latter is 5 to 50% by weight, preferably such that the former is 60 to 90% by weight and the latter is 10 to 40% by weight, and more preferably such that the former is 70 to 85% by weight and the latter is 15 to 30% by weight.

The radical polymerization type resin used in this invention is classified into acrylates having a cyclic structure in the molecule and the other acrylates. Said the other acrylates include, for example, mono-, di- and tri-acrylates of various alcohols, acrylates of modified alcohols and the like.

The acrylates having a cyclic structure in the molecule include, for example, acrylates having a cycloaliphatic group such as a dicyclopentanyl ring, a dicyclopentenyl ring, an isobornyl ring, a cyclohexanyl ring, a cyclohexenyl ring or the like; acrylates having a non-aromatic heterocyclic group such as a morpholinyl ring, a piperidine ring, a piperazine ring, an imidazoline ring, an imidazolidine ring or the like; acrylates having an aromatic group such as a benzene ring, a naphthalene ring, a pyrimidine ring, a furan ring, an imidazole ring, a pyridine ring, a picoline ring, a quinazoline ring, a quinazolidine ring, an anthracene ring, a fluorene ring or the like; and the like. These acrylates having a cyclic structure in the molecule are preferably acrylates having a dicyclopentanyl ring, a dicyclopentenyl ring, an isobornyl ring, a morpholinyl ring, a benzene ring or a cyclohexane ring, and more preferably those acrylates having a viscosity of not more than 50 cps as measured by an E type viscometer at 25°C, and particularly preferably acrylates having a cycloaliphatic group which includes specifically dicyclopentanyl monoacrylate, dicyclopentanyl monomethacrylate, dicyclopentanyl diacrylate, dicyclopentanyl dimethacrylate, dicyclopentenyloxyethyl acrylate, dicyclopentenyloxyethyl methacrylate, isobornyl acrylate, isobornyl methacrylate, morpholinyl acrylate, morpholinyl methacrylate, phenoxydiethylene glycol methacrylate, cyclohexyl acrylate, cyclohexyl methacrylate and the like. Furthermore, in view of the adhesiveness to substrate, the acrylate having a cyclic structure in the molecule is preferably a monoacrylate having a cycloaliphatic group, for example, a monoacrylate having a dicyclopentanyl ring or isobornyl ring as the cycloaliphatic group. Specific examples thereof include dicyclopentanyl monoacrylate, dicyclopentanyl monomethacrylate, dicyclopentenyloxyethyl monoacrylate, dicyclopentenyloxyethyl monomethacrylate, isobornyl monoacrylate, isobornyl monomethacrylate and the like.

The monoacrylates of various alcohols include, for example, acrylates of saturated and unsaturated alcohols having 1 to 23 carbon atoms such as 2-hydroxypropyl acrylate, 2-hydroxypropyl methacrylate, lauryl acrylate, stearyl acrylate, palmityl acrylate, oleyl acrylate and the like, and acrylates of saturated and unsaturated alcohols having 8 to 23 carbon atoms having a viscosity of not more than 50 cps as measured by an E type viscometer at 25°C are preferable and those having 12 to 23 carbon atoms, which include lauryl acrylate, stearyl acrylate, palmityl acrylate and oleyl acrylate are more preferable. Lauryl acrylate is most preferable.

The diacrylates and triacrylates of various alcohols include, for example, di- and triacrylates of polyhydric alcohols such as ethylene glycol, propylene glycol, butanediol, pentanediol, heptanediol, octanediol, diethylene glycol, triethylene glycol, dipropylene glycol, polypropylene glycol, glycerine and the like, and preferable are di- and triacrylates of polyhydric alcohols such as ethylene glycol, propylene glycol, diethylene glycol, triethylene glycol, dipropylene glycol, polyethylene glycol, polypropylene glycol and the like. More preferable are those di- and triacrylates having a viscosity of not more than 50 cps as measured by an E type viscometer at 25°C, for example, di- and triacrylates of polyhydric alcohols such as ethylene glycol, propylene glycol, diethylene glycol, dipropylene glycol, neopentyl glycol and the like. Specifically, there are mentioned diethylene glycol diacrylate, diethylene glycol dimethacrylate, tripropylene glycol diacrylate and neopentyl glycol diacrylate, and preferable are diethylene glycol diacrylate, tripropylene glycol diacrylate and neopentyl glycol diacrylate.

The acrylates of modified alcohols are acrylates of modified monoalcohols in which monoalcohols have been modified with a modifying agent which produces a hydroxyl group by modification and acrylates of modified polyhydric alcohols in which a part of the hydroxyl groups of the polyhydric alcohol has been modified with a modifying agent which can react with a hydroxyl group (the modifying agent may have a hydroxyl group). The modifying agent includes butyrolactone, caprolactone, epichlorohydrin, ethylene oxide, propylene oxide, butylene oxide, aliphatic aldehydes having 1 to 6 carbon atoms; aromatic aldehydes such as benzaldehyde, p-methoxybenzaldehyde, p-hydroxybenzaldehyde, p-nitrobenzaldehyde, p-chlorobenzaldehyde and the like; aliphatic carboxylic acids having 1 to 6 carbon atoms; aromatic carboxylic acids such as benzoic acid, phthalic acid, p-hydroxybenzoic acid, p-nitrobenzoic acid, p-hydroxybenzoic acid, p-chlorobenzoic acid and the like; aliphatic aldehydes having a hydroxyl group such as lactaldehyde, tartaraldehyde, citraldehyde, hydroxypivalaldehyde and the like; aliphatic carboxylic acids having a hydroxyl group such as lactic acid, tartaric acid, citric acid, hydroxypivalic acid and the like; etc. The acrylates of modified alcohols are preferably acrylates of alcohols modified with caprolactone, epichlorohydrin, hydroxypivalaldehyde, hydroxypivalic acid or ethylene oxide, and more preferably those acrylates having a viscosity of not more than 50 cps as measured by an E type viscometer at 25°C including, for example, caprolactone-modified 2-hydroxyethyl acrylate, hydroxypivalic acid-modified neopentyl glycol diacrylate and 2-[2-(ethyloxy)ethyloxy]ethyl acrylate. Caprolactone-modified 2-hydroxyethyl acrylate, hydroxyvivalic acid-modified neopentyl glycol diacrylate and 2-[2-(ethyloxy)ethyloxy]ethyl acrylate are preferred.

The acrylates having a cyclic structure in the molecule and the other acrylates are preferably used in admixture of the two when the adhesiveness to a substrate, particularly an aluminum-made substrate is taken into consideration, and the mixing proportion thereof is such that the former is 50 to 95% by weight and the latter is 5 to 50% by weight, more preferably such that the former is 60 to 90% by weight and the latter is 10 to 40% by weight, and most preferably such that the former is 70 to 85% by weight and the latter is 15 to 30% by weight.

When a resin having a viscosity of not more than 50 cps as measured by an E type viscometer at 25°C is used as the above-mentioned energy beam-curable resin, it is possible to enhance the adhesiveness and curability by adding to the above resin various acrylates having a viscosity of more than 50 cps as measured by an E type viscometer at 25°C, various oligomers or various epoxy reins to such an extent that the spray-coatability of the liquid composition is not affected. The various acrylates having a viscosity of more than 50 cps as measured by an E type viscometer at 25°C include acrylate type resins having at least one member selected from the group consisting of dicyclopentanyl ring, dicyclopentenyl ring, isobornyl ring, morpholinyl ring, benzene ring and cyclohexane ring; caprolactone-modified acrylate type resins; epichlorohydrin-modified acrylate type resins; hydroxypivalaldehyde-modified acrylate type resins; hydroxypivalic acid-modified acrylate type resins; ethylene oxide-modified acrylate type resins, monoacrylate type resins; di- or triglycol acrylate type resins; and the like. Preferable are epichlorohydrin-modified 1,6-hexanediol diacrylate, ethylene oxide-modified trimethylolpropane triacrylate, pentaerythritol triacrylate, polyethylene glycol diacrylate, trimethylolpropane triacrylate, 5-ethyl-2-(2-hydroxy-1,1-dimethylethyl)-5-(hydroxymethyl)-1,3-dioxane diacrylate and the like.

The oligomers include epoxyacrylate oligomers such as epoxidized soy bean oil acrylate, acrylates of various bisphenol A type epoxy resins, epoxidized linseed oil acrylate, modified bisphenol A diacrylate and the like; polyester acrylate oligomers such as reaction products of acrylic acid with polyesters formed from an aliphatic diol and a dibasic acid, as represented by the following formula (2): 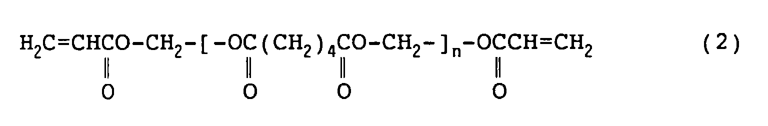 wherein n is an average value of 1 to 10; aliphatic or aromatic urethane acrylates obtained by reaction of an aliphatic or aromatic isocyanate with a polyol or polyester, as represented by the following formula (3): 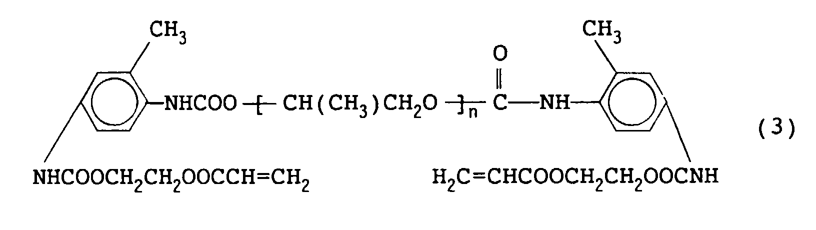 wherein n is an average value of 1 to 10; and the like. The amount of these oligomers added may be such that the viscosity of the composition as measured by an E type viscometer at 60°C becomes not more than 20 cps; however, said amount is usually not more than 20% by weight, preferably not more than 15% by weight and more preferably not more than 10% by weight, based on the total weight of the resins.

In the liquid composition of this invention, when, for example, an ultraviolet ray is used as the energy beam for curing, it is preferable to use a photopolymerization initiator. As such a photopolymerization initiator, for the radical polymerization type resins, there is used a known photopolymerization initiator of thioxanthone type, anthraquinone type, acetophenone type, benzoin ether type, benzophenone type, amine type or the like; and for the cationic polymerization type resins, there is used such a known photopolymerization initiators as aromatic diazonium salt, an aromatic halonium salt, a metallocene compound or the like. These photopolymerization initiators may be used alone or in admixture of two or more. When the cationic polymerization type resin is used, in order to make the curing more complete, it is desirable to heat in a temperature range of from 80°C to 170°C, particularly preferably in a temperature range of from 100°C to 150°C. The heating time may be varied depending upon the temperature, and it is usually 5 to 30 minutes.

The leuco dye used in this invention includes, for example, leuco dyes represented by the formula (1), 2,2-bis{4-[6'-(N-cyclohexyl-N-methylamino)-3'-methylspiro(phthalido-3,9'-xanthene)-2'-ylamino]phenyl}propane (trade name: Papirol SD-120, manufactured by Showa Denko K. K.) and the like. In the formula (1), the alkyl group having 1 to 4 carbon atoms in the definitions of R₁ and R₂ include, for example, methyl group, ethyl group, n-propyl group, isopropyl group, n-butyl group, isobutyl group, sec-butyl group and tert-butyl group, and the halogen atom in the definition of X includes, for example, fluorine atom, chlorine atom, bromine atom and iodine atom. When n is 2, the two X groups may be the same as or different from each other. The leuco dyes represented by the formula (1) include, for example, 3-diethylamino-7-o-fluoroanilinofluoran, 3-dibutylamino-7-o-fluoroanilinofluoran, 3-diethylamino-7-p-fluoroanilinofluoran, 3-dibutylamino-7-p-fluoroanilinofluoran, 3-diethylamino-7-o-chloroanilinofluoran, 3-dibutylamino-7-o-chloroanilinofluoran, 3-diethylamino-7-p-chloroanilinofluran, 3-dibutylamino-7-p-chloroanilinofluoran, 3-diethylamino-7-p-chloro-o-fluoroanilinofluoran, 3-diethylamino-7-p-fluoro-o-chloroanilinofluoran, 3-dimethylamino-7-p-chloro-o-fluoroanilinofluoran, 3-dibutylamino-7-p-fluoro-o-chloroanilinofluoran, 3-diethylamino-7-2',4'-dichloroanilinofluoran, 3-dimethylamino-7-2',4'-dichloroanilinofluoran and the like.

When the amount of the leuco dye used is too small, no vivid mark is obtained and when it is too large, no more vivid mark is obtained and it brings about only an increase of cost. Therefore, the amount is preferably about 5 to 30% by weight, more preferably about 7 to 20% by weight, and most preferably about 8 to 15% by weight, based on the weight of the energy beam-curable resin. Moreover, as a leuco dye giving a transparent coating film while maintaining the metal gloss of a metal substrate, particularly aluminum, particularly excellent are, for example, 3-diethylamino-7-o-fluoroanilinofluoran, 3-dibutylamino-7-o-fluoroanilinofluoran, 3-diethylamino-7-o-chloroanilinofluoran and 3-dibutylamino-7-o-chloroanilinofluoran.

The developer used in this invention includes, for example, bisphenol S type developers such as 4,4'-sulfonyldiphenol, 2,2',6,6'-tetramethyl-4,4'-sulfonyldiphenol, 2,2',6,6'-tetrabromo-4,4'-sulfonyldiphenol, 2,2'-diallyl-4,4'-sulfonyldiphenol and the like; bisphenol A type developers such as bis(p-hydroxyphenyl)methane, 1,1-bis(p-hydroxyphenyl)cyclohexane, 4,4'-isopropylidenephenol and the like; biphenol type developers such as 4,4'-dihydroxybiphenyl, 4,4'-dihydroxy-3,3',5,5'-tetramethylbiphenyl and the like; phenol type aromatic carboxylic acid derivatives such as p-octylphenol, p-phenylphenol, benzyl p-hydroxybenzoate, 4-hydroxyphthalic acid, 5-hydroxyphthalic acid, 3,5'-ditert-butylsalicylic acid, salicylic acid, benzyl β-hydroxynaphthalenecarboxylate and the like; and polyvalent metal salts of the phenol type aromatic carboxylic acids.

The amount of the developer used is preferably about 5 to 30% by weight, more preferably about 7 to 20% by weight and most preferably about 8 to 15% by weight, based on the weight of the energy beam-curable resin. Moreover, as a developer which gives a transparent coating film while maintaining the metal gloss of a metal substrate, particularly aluminum, there are mentioned, for example, 4,4'-isopropylidenediphenol, 1,1-bis(p-hydroxyphenyl)cyclohexane, 4,4'-dihydroxybisphenyl, 4,4'-sulfonyldiphenol, 2,2'-diallyl-4,4'-sulfonyldiphenol and 4-(4'-isopropoxyphenyl)sulfonylphenol, and particularly excellent are 4-(4'-isopropoxyphenylsulfonylphenol, 2,2'-diallyl-4-,4'-sulfonyldiphenol and 4,4'-sulfonyldiphenol.

The proportions of the above-mentioned components in the liquid composition of this invention are such that the proportion of the leuco dye is preferably 2 to 20% by weight, more preferably 4 to 15% by weight, and most preferably 6 to 12% by weight; the proportion of the developer is preferably 2 to 20% by weight, more preferably 4 to 15% by weight and most preferably 6 to 12% by weight; the proportion of the energy beam-curable resin is preferably 45 to 96% by weight, more preferably 58 to 92% by weight and most preferably 60 to 88% by weight, the above proportions being based on the weight of the liquid composition. When, for example, an ultraviolet ray is used as the energy beam for the curing, a photopolymerization initiator is further used in an amount of preferably 2 to 15% by weight, more preferably 4 to 15% by weight and most preferably 6 to 10% by weight, based on the weight of the liquid composition.

The liquid composition of this invention can have, if necessary, other additives and the like. The said other additives which can be used include sensitizers for increasing the color development sensitivity, and in addition, fillers, colorants, dispersing agents, fluidity-controlling agents, releasing agents, flame-retardants, lubricants, light-stabilizers, antioxidants and the like which are usually used in the energy beam-curable coating. As the sensitizers, there are used, for example, higher fatty acid amides such as stearic acid amide and the like; animal waxes such as bees wax, shellac wax and the like; vegetable waxes such as carnauba wax and the like; mineral waxes such as montan wax and the like; paraffin waxes; petroleum waxes; higher fatty acid esters; chlorinated paraffins; synthetic paraffins, acetoacetic acid anilides; carboxylic acid esters such as dimethyl terephthalate, diphenyl phthalate and the like; sulfonic acid amides such as benzenesulfonic acid anilide and the like; sulfonic acid esters such as phenyl p-toluenesulfonate and the like; diphenylsulfones such as bis[4-(4-pentyloxyphenyl)sulfone] and the like; naphthol derivatives such as 1-benzyloxynaphthalene, 2-benzoyloxynaphthalene and the like; N-stearylurea derivatives; and diketone compounds such as 4-acetylacetophenone, octadecane-2,17-dione and the like. The amount of the sensitizer used is usually 0.5 to 2 parts by weight per part by weight of the developer.

The fillers which can be used in this invention include inorganic fillers such as calcium carbonate, silica, alumina, mica, calcium silicate, clay, talc, glass fiber and the like and organic fillers such as polyethylene, polyamide, epoxy resin, guanamine resin and the like. In addition, the colorants which can be used in this invention include organic coloring matters such as phthalocyanine, monoazo, disazo, quinacridone, anthraquinone, flavanthrone, perinone, perylene, dioxazine, condensed azo, azomethine and methine type organic coloring matters; and inorganic pigments such as carbon black, titanium oxide, lead sulfate, zinc oxide, iron black, chrome yellow, zinc yellow, chrome vermilion, red iron oxide, cobalt violet, ultramarine, prussian blue, chrome green, cobalt green and the like. The amount of the colorant used is such an amount that the viscosity as measured by an E type viscometer at 60°C becomes not more than 20 cps, and it is usually such that the amount of the filler becomes not more than 30% by weight of the total weight of the solid content. The amount of the colorant used is in such a range that the vividness of mark is not adversely affected and is usually not more than 1 w/w % of the total solid content.

In this invention, the liquid composition of this invention is obtained by uniformly mixing, when it is used, a "leuco dye ink" prepared by mixing the energy beam-curable resin, the leuco dye and, if necessary, the photopolymerization initiator, the filler, the colorant, a dispersing agent, a fluidity-controlling agent, a releasing agent, a flame-retardant, a lubricant, a light stabilizer, an antioxidant and the like in a stirring apparatus such as a three-roll mill or the like preferably at a temperature of 15 to 30°C with a "developer ink" prepared by mixing the energy beam-curable resin, the developer and, if necessary, the photopolymerization initiator, the filler, the colorant, a dispersing agent, a fluidity-controlling agent, a releasing agent, a flame-retardant, a lubricant, a light stabilizer, an antioxidant and the like in a dispersing apparatus such as a three-roll mill or the like preferably at a temperature of 15 to 30°C, and is used as the marking agent of this invention. In the production of the above ink, only the photopolymerization initiator may be dissolved in the energy beam-curable resin to prepare a "photopolymerization initiator ink" and this may be used together with the leuco dye ink freed from the photopolymerization initiator and the developer ink. Among the components used in this invention, those which are present in the solid form have preferably a particle size of not more than 20 µm, more preferably not more than 15 µm.

The laser marking article of this invention is an article having on its surface a cured film of the above-mentioned liquid composition. The article includes, for example, bottles, caps, cards, labels and cans. The film thickness of the above-mentioned liquid composition (referred to hereinafter as the laser marking composition in some cases) present on the surface of the article is 3 to 50 µm, preferably 4 to 30 µm and more preferably 5 to 20 µm. As the material constituting the article, for example, a metal such as aluminum or the like is suitable.

For producing the laser marking article of this invention, the above-mentioned laser marking composition is coated on the surface of the article by a method such as a spray coating method or the like, and thereafter, the coating surface was irradiated with an energy beam such as an infrared ray, a visible light, an ultraviolet ray, an electron beam or the like except laser, preferably with an ultraviolet ray or an electron beam to cure the composition.

The spray coating is a coating method in which the ink is passed through a nozzle under pressure to be converted to foggy droplets having a diameter of not more than several hundreds of µm and the resulting foggy droplets are blown against the substrate to coat the substrate. As the method of forming foggy droplets, there are two methods, one of which is a method using compressed air and the other is a method in which the ink per se is compressed by a pressure pump to be formed into foggy droplets, and both of them can be used in this invention. For obtaining a uniform, thin film having a thickness of 3 to 50 µm in this invention, the foggy droplets obtained by spraying have a diameter of 0.5 µm to several hundreds of µm, preferably 1 µm to 100 µm and more preferably 2 µm to 80 µm. For obtaining such fine foggy droplets, the viscosity of the ink is the most important factor, and the lower the viscosity of the ink, the finer the foggy droplets. The viscosity of the ink is not more than 20 cps as measured by an E type viscometer at 60°C, preferably not more than 20 cps as measured by an E type viscometer at 50°C and more preferably not more than 20 cps as measured by a viscometer at 40°C. Moreover, since the ink of this invention has a low viscosity, the ink has an applicability for gravure printing requiring a low viscosity.

The E type viscometer referred to herein is a kind of rotational viscometer in which the resistance caused by rotating a disc, a cylinder, a corn plate or the like in the ink is taken in relation to the force applied and the revolution speed to calculate a viscosity and a yield value, and it is possible to measure the viscosity using a relatively small amount of a sample. Therefore, in general, the viscometer is often used.

The laser marking process of this invention can be carried out, for example, in the following manner:

The liquid composition (marking composition) of this invention is coated on the surface of a molded product (article) to be marked by a spray coating method so that the thickness of the cured film becomes 3 to 50 µm, and irradiated with an energy beam except laser to be cured, after which the coated article having the cured film on its surface was irradiated with a laser beam, to obtain a black marking having a vivid contrast. The laser beam applied is preferably such a pulse type laser that the energy density in the portion irradiated becomes 0.5 to 6 J/cm², preferably 0.5 to 5.0 J/cm², more preferably 1.0 to 4.0 J/cm² and most preferably 1.2 to 3.5 J/cm², or such a scanning type laser that the output is 5 to 100 watts, preferably 10 to 90 watts and more preferably 15 to 80 watts. The laser which can be used in this invention includes carbon dioxide gas laser, YAG laser, excimer laser and the like, and an infrared ray laser, particularly a far infrared ray laser such as a TEA type carbon dioxide gas laser or the like is preferred.

The material (substrate) of the molded article includes plates of a metal such as aluminum, iron or the like; papers such as metallized paper, coated paper, synthetic paper and the like; plastic films in which polyvinyl chloride, polyethylene, polypropylene, a polyester such as polyethylene terephthalate or polybutylene terephthalate, or the like is used as a base material; and plastic plates in which a usually used plastic including these plastics, acrylic resins, ABS resins and the like is used as a base material. Among them, preferred is aluminum. The laser marking article of this invention may be any article which is desired to be marked using a laser beam and the kind of the article is not critical. The article includes, for example, cans made of metals; various containers for foods and medicines; caps for the containers; sheets; packaging sheets; wrapping films; cards; labels; bottles; and the like, on the surfaces of which maker's name, contents, production date, lot number and the like are to be indicated.

According to this invention, an energy beam-curable, liquid composition for laser marking which composition has a low viscosity suitable for spray coating and gravure printing can be obtained without using a solvent or a dispersing agent, and the cured film of this liquid composition is characterized in that Discoloration of the ground is little, the adhesiveness to substrate is good, the portion irradiated with a laser beam becomes vivid black and the color is excellent in fastness.

### DESCRIPTION OF THE PREFERRED EMBODIMENTS

Reference Examples and Examples are shown below to explain this invention in more detail; however, this invention should not be construed to be limited to them. Incidentally, in the Reference Examples and the Examples, part is by weight unless otherwise specified.

### Reference Example 1

On a three-roll mill, 55 parts of isobornyl acrylate and 30 parts of 3-diethylamino-7-o-fluoroanilinofluoran were treated twice to be uniformly mixed, thereby obtaining a leuco dye ink (referred to hereinafter as Leuco Dye Ink A).

### Reference Example 2

On a three-roll mill, 55 parts of dicyclopentanyl acrylate and 30 parts of 3-diethylamino-7-o-fluoroanilinofluoran were treated twice to be uniformly mixed, thereby obtaining a leuco dye ink (referred to hereinafter as Leuco Dye Ink B).

### Reference Example 3

On a three-roll mill, 55 parts of isobornyl acrylate and 30 parts of 4-(4'-isopropoxyphenyl)-sulfonylphenol were treated twice to be uniformly mixed, thereby obtaining a developer ink (referred to hereinafter as Developer Ink C).

### Reference Example 4

On a three-roll mill, 55 parts of dicyclopentenyl acrylate and 30 parts of 4-(4'-isopropoxyphenyl)sulfonylphenol were treated twice to be uniformly mixed, thereby obtaining a developer ink (referred to hereinafter as Developer Ink D).

### Reference Example 5

In 40 parts of isobornyl acrylate were dissolved 5 parts of Irgacure 184 (photopolymerization initiator manufactured by Ciba Geigy), 2 parts of Irgacure 907 (photopolymerization initiator manufactured by Ciba Geigy) and 0.3 part of methoquinone at 80°C, and thereafter, the resulting solution was cooled to 25°C to obtain a photopolymerization initiator ink (referred to hereinafter as Photopolymerization Initiator Ink E).

### Reference Example 6

In 40 parts of dicyclopentanyl acrylate were dissolved 5 parts of Irgacure 184, 2 parts of Irgacure 907 and 0.3 part of methoquinone at 80°C, and thereafter, the resulting solution was cooled to 25°C to obtain a photopolymerization initiator ink (referred to hereinafter as Photopolymerization Initiator Ink F).

### Reference Example 7

On a three-roll mill, 25 parts of isobornyl acrylate and 30 parts of 4-(4'-isopropoxyphenol)-sulfonylphenol were treated twice to be uniformly mixed, thereby obtaining a developer ink (referred to hereinafter as Developer Ink N).

### Reference Example 8

In 30 parts of isobornyl acrylate were dissolved 10 parts of Irgacure 184 and 0.3 part of methoquinone at 80°C, and thereafter, the resulting solution was cooled to 25°C to obtain a photopolymerization initiator ink (referred to hereinafter as Photopolymerization Initiator Ink O).

### Examples 1 to 10 and 15 to 19

At the composition ratio shown in Table 1, the above-mentioned leuco dye inks, the above-mentioned developer inks and the above-mentioned photopolymerization initiator inks were mixed to prepare liquid compositions (this invention). These liquid compositions all had a viscosity of not more than 20 cps as measured by an E type viscometer (Model DVR-E2; TOKIMEKKU Co., Ltd.) at 60°C as shown in Table 2. Each of these liquid compositions was used as the marking agent in this invention and coated on an aluminum substrate by an airless spray coater (crosscut nozzle type, 06/16", spray time: 50 msec) manufactured by Nordson Company to find that the marking agent (ink) was well formed into foggy droplets, and coated articles each having a uniform coating film were obtained. Each of the coated articles was irradiated with an ultraviolet ray to cure the marking agent, thereby obtaining test specimens each having a cured film thickness of 10 to 15 µm. Each of the test specimens obtained was irradiated with a laser beam (energy density: 3.0 J/cm²) using a pulse type carbon dioxide gas laser irradiation machine (BLAZAR 6000 manufactured by Laser Technics) to obtain vivid black marks. The developed color density, water resistance, hot water resistance and adhesiveness of each of the marked test specimens are shown in Table 2. In order to confirm the degree of Discoloration of the ground of the marking agent, the marking composition of this invention was coated on a white polyethylene terephthalate film using Bar Coater No. 7 and irradiated with an ultraviolet ray from a high pressure mercury vapor lamp to be cured, thereby obtaining test specimens for evaluation. The results are shown in Table 2.

### Examples 11 to 14 and 20 to 21

At the composition ratio shown in Table 1, the above-mentioned leuco dye inks, the above-mentioned developer inks and the above-mentioned photopolymerization initiator inks were mixed to prepare liquid compositions (this invention). These liquid compositions all had a viscosity of not more than 20 cps as measured by an E type viscometer at 60°C as shown in Table 2. Each of these liquid compositions was used as the marking agent of this invention and coated on an aluminum substrate by an airless spray coater (crosscut nozzle type: 06/16", spray time: 50 msec) manufactured by Nordson Company to find that the marking agent (ink) was well formed into foggy droplets, and coated articles each having a uniform coating film were obtained. Each of the coated articles was irradiated with an electron beam of 6 mega rads (using an electron beam generator CB 175/15/180L manufactured by IWASAKI ELECTRIC CO. LTD.) to cure the marking agent, thereby obtaining test specimens each having a cured film thickness of 10 to 15 µm. Each of the test specimens obtained was irradiated with a laser beam (energy density: 3.0 J/cm²) in the same manner to obtain vivid black marks. The developed color density, water resistance, hot water resistance and adhesiveness of each of the marked test specimens are shown in Table 2. In order to confirm the degree of Discoloration of the ground of the marking agent, the marking composition of this invention was coated on a white polyethylene terephthalate film using Bar Coater No. 7 and irradiated with an electron beam of 6 mega rads to be cured, thereby obtaining test specimens for evaluation. The results are shown in Table 2.

### Comparative Example 1

On a three-roll mill, 60 parts of epoxyacrylate (KAYARAD R-011 manufactured by NIPPON KAYAKU CO., LTD.), 40 parts of trimethylolpropane triacrylate, 3 parts of Irgacure 184, 0.3 part of methoquinone, 0.3 part of 2,4-diethylthioxanthone, 0.1 part of a fluidity-controlling agent (trade name: Modaflow, manufactured by Monsanto Chemical) and 30 parts of 3-diethylamino-7-o-fluoroanilinofluoran were treated twice to be uniformly mixed, thereby obtaining a leuco dye ink for comparison (referred to hereinafter as Comparative Leuco Dye Ink). Moreover, the same procedure as above was repeated, except that bis(3-allyl-4-hydroxyphenyl)sulfone was substituted for the 3-diethylamino-7-o-fluoroanilinofluoran, to obtain a developer ink for comparison (referred to hereinafter as Comparative Developer Ink). Subsequently, the two were uniformly mixed at a 1:1 ratio to prepare a sample for Comparative Example 1. This sample had a viscosity of 2,000 cps as measured by an E type viscometer at 25°C and a viscosity of 130 cps as measured by an E type viscometer at 60°C. This sample had too high a viscosity to be spray-coated, so that this was coated on an aluminum substrate by Bar Coater No. 7 and then irradiated with an ultraviolet ray from a high pressure mercury vapor lamp to cure the sample liquid, thereby obtaining a test specimen having a cured coating film of 20 µm in thickness. This test specimen was irradiated with a laser beam (energy density: 3.0 J/cm²) using a pulse type carbon dioxide gas laser irradiation machine (BLAZAR 6000 manufactured by Laser Technics) to obtain a vivid black mark. The developed color density, water resistance, hot water resistance and adhesiveness of the marked test specimen are shown in Table 2. Moreover, in order to confirm the degree of Discoloration of the ground, this sample liquid was coated on a white polyethylene terephthalate film by Bar Coater No. 7 and then irradiated with an ultraviolet ray from a high pressure mercury vapor lamp to cure the sample liquid, thereby obtaining a test specimen for evaluation. The results are shown in Table 2.

Incidentally, the numerals in Table 1 are parts by weight and A to F, N and O refer to the inks of References Examples 1 to 8, respectively, and G to M and P to the following acrylates:
- G:: Pentaerythritol triacrylate
- H:: Polyethylene glycol 400 triacrylate
- I:: Trimethylolpropane triacrylate
- J:: Epichlorohydrin-modified 1,6-hexanediol diacrylate
- K:: Bisphenol A epoxy resin acrylate
- L:: Isobornyl acrylate
- M:: Dicyclopentanyl acrylate
- P:: Tripropylene glycol diacrylate

**Table 1**

| Example No. | A | B | C | D | E | F | G | H | I | J | K | L | M | N | O | P |
|---|---|---|---|---|---|---|---|---|---|---|---|---|---|---|---|---|
| 1 | 85 | | 85 | | 94.6 | | 10 | | | | | | | | | |
| 2 | 85 | | 85 | | 94.6 | | | 10 | | | | | | | | |
| 3 | 85 | | 85 | | 94.6 | | | | 10 | | | | | | | |
| 4 | 85 | | 85 | | 94.6 | | | | | 10 | | | | | | |
| 5 | 85 | | 85 | | 94.6 | | | | | | 10 | | | | | |
| 6 | | 85 | | 85 | | 94.6 | 10 | | | | | | | | | |
| 7 | | 85 | | 85 | | 94.6 | | 10 | | | | | | | | |
| 8 | | 85 | | 85 | | 94.6 | | | 10 | | | | | | | |
| 9 | | 85 | | 85 | | 94.6 | | | | 10 | | | | | | |
| 10 | | 85 | | 85 | | 94.6 | | | | | 10 | | | | | |
| 11 | 85 | | 85 | | | | | | | 10 | | 100 | | | | |
| 12 | 85 | | 85 | | | | | | 10 | | | 100 | | | | |
| 13 | | 85 | | 85 | | | 10 | | | | | | 100 | | | |
| 14 | | | | | | | | 10 | | | | | 100 | | | |
| 15 | 85 | | | | | | 10 | | | | | 30 | | 55 | 80.6 | 20 |
| 16 | 85 | | | | | | 20 | | | | | | | 55 | 80.6 | 40 |
| 17 | 85 | | | | | | | | 10 | | | 30 | | 55 | 80.6 | 20 |
| 18 | 85 | | | | | | | | | | 10 | 30 | | 55 | 80.6 | 20 |
| 19 | 85 | | | | | | 30 | | | | | 30 | | 55 | 80.6 | |
| 20 | 85 | | | | | | 10 | | | | | 90 | | 55 | | 20 |
| 21 | 85 | | | | | | 20 | | | | | 60 | | 55 | | 40 |

**Table 2**

| Example No. | Viscosity | Discoloration of the ground | Transparency | Developed color density | Water resistance | Hot water resistance | Adhesiveness |
|---|---|---|---|---|---|---|---|
| 1 | 11 | 0.10 | ○ | 0.72 | 0.70 | 0.65 | ○ |
| 2 | 15 | 0.10 | ○ | 0.76 | 0.73 | 0.63 | ○ |
| 3 | 13 | 0.10 | ○ | 0.75 | 0.74 | 0.67 | ○ |
| 4 | 11 | 0.10 | ○ | 0.76 | 0.76 | 0.66 | ○ |
| 5 | 20 | 0.10 | ○ | 0.73 | 0.72 | 0.67 | ○ |
| 6 | 15 | 0.10 | ○ | 0.72 | 0.70 | 0.65 | ○ |
| 7 | 18 | 0.10 | ○ | 0.74 | 0.73 | 0.68 | ○ |
| 8 | 17 | 0.10 | ○ | 0.78 | 0.78 | 0.69 | ○ |
| 9 | 15 | 0.01 | ○ | 0.76 | 0.73 | 0.65 | ○ |
| 10 | 20 | 0.09 | ○ | 0.75 | 0.75 | 0.70 | ○ |
| 11 | 10 | 0.09 | ○ | 0.76 | 0.76 | 0.74 | ○ |
| 12 | 10 | 0.10 | ○ | 0.76 | 0.73 | 0.73 | ○ |
| 13 | 13 | 0.10 | ○ | 0.77 | 0.75 | 0.74 | ○ |
| 14 | 13 | 0.10 | ○ | 0.77 | 0.76 | 0.75 | ○ |
| 15 | 11 | 0.10 | ○ | 0.72 | 0.70 | 0.65 | ○ |
| 16 | 15 | 0.10 | ○ | 0.76 | 0.73 | 0.63 | ○ |
| 17 | 13 | 0.10 | ○ | 0.75 | 0.74 | 0.67 | ○ |
| 18 | 11 | 0.10 | ○ | 0.76 | 0.76 | 0.66 | ○ |
| 19 | 20 | 0.10 | ○ | 0.73 | 0.72 | 0.67 | ○ |
| 20 | 10 | 0.10 | ○ | 0.72 | 0.70 | 0.65 | ○ |
| 21 | 12 | 0.11 | ○ | 0.72 | 0.71 | 0.66 | ○ |
| Comparative Example 1 | 130 | 0.13 | ○ | 1.30 | 1.30 | 1.20 | X |

The evaluation items in Table 2 were measured by the following methods:
(1) Viscosity:
   Values (cps) obtained by measurement by an E type viscometer at 60°C.
(2) Discoloration of the ground:
   Developed color density obtained by subjecting the polyethylene terephthalate film test specimen for measuring Discoloration of the ground to measurement by a Macbeth reflection densitometer Model RD-914.
(3) Transparency:
   Whether the metal color of the aluminum test specimen was maintained or not was visually judged.
      - o:: Coating film was transparent and aluminum substrate was clearly confirmed.
      - △:: Coating film was translucent and the metal color of aluminum substrate was seen somehow.
      - x:: Coating film was opaque and the metal color of aluminum substrate was not seen at all.
(4) Developed color density:
   Developed color density obtained by subjecting the marked portion of test specimen to measurement by a Macbeth reflection densitometer Model RD-914.
(5) Water resistance:
   Developed color density obtained by immersing marked test specimen in cold water at 5°C for one week and then subjecting the marked portion to measurement by a Macbeth reflection densitometer.
(6) Hot water resistance:
   Developed color density obtained by immersing marked test specimen in hot water at 60°C for one hour and then subjecting the marked portion to measurement by a Macbeth reflection densitometer.
(7) Adhesiveness:
   The coating film on the test specimen was cut in the lattice form so that the cut reached the aluminum substrate and an adhesive tape was attached to the coating film cut in the lattice form and then peeled off and thereafter the state of the coating film adhering to the substrate was visually judged.
      - o:: At the crossing points of the cuts, a slight peel was found; however, each square was not peeled off.
      - △:: Peeling was found at the crossing points of the cuts and the damaged area was 20 to 30% of the total square area.
      - x:: The coating film was completely peeled off.

From the data in Table 2, it can be seen that the liquid composition of this invention was low in viscosity, the cured film of the composition was little in Discoloration of the ground, excellent in transparency and adhesiveness, and also excellent in color developability, water resistance and hot water resistance. Moreover, from comparison between the data of the Examples and the data of Comparative Example 1 shown in Table 2, it can be seen that the liquid composition of this invention was lower in viscosity than Comparative Example 1 and the cured coating film was superior in adhesiveness to Comparative Example 1.

## Claims

1. A liquid composition which comprises an energy beam-curable resin, a leuco dye and a developer and has a viscosity of not more than 20 cps as measured by an E type viscometer at 60°C.

2. The liquid composition according to Claim 1, wherein the energy beam-curable resin is a resin having no proton-emitability.

3. The liquid composition according to Claim 2, wherein the resin having no proton-emitability is composed of an acrylate type resin having a cyclic structure in the molecule and another energy-beam curable resin and the viscosity of one of the resins or the viscosities of both the resins are not more than 50 cps as measured by an E type viscometer at 25°C.

4. The liquid composition according to Claim 3, wherein the acrylate type resin having a cyclic structure in the molecule is an acrylate type resin having a cycloaliphatic group.

5. The liquid composition according to Claim 4, wherein the acrylate type resin having a cycloaliphatic group is an acrylate type resin having a dicyclopentanyl ring or an isobornyl ring.

6. The liquid composition according to Claim 4, wherein the acrylate type resin having a cycloaliphatic group is dicyclopentanyl acrylate or isobornyl acrylate.

7. The liquid composition according to Claim 3, wherein the content of the acrylate resin having a cyclic structure in the molecule is 50 to 95% by weight in the resin having no proton-emitability.

8. The liquid composition according to Claim 1, wherein the leuco dye is a fluoran compound represented by the formula (1): 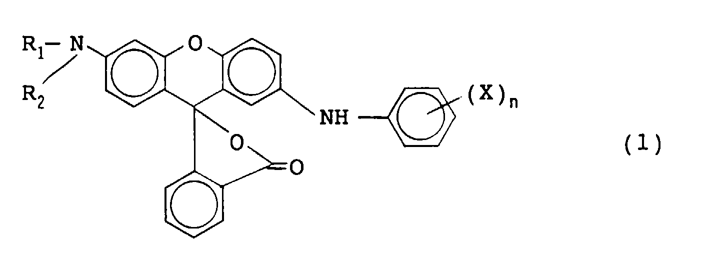 wherein each of R₁ and R₂ represents an alkyl group having 1 to 4 carbon atoms, X represents a halogen atom and n represents an integer of 1 or 2 and wherein when n is 2 the two X groups may be the same as or different from each other, or 2,2-bis{4-[6'-(N-cyclohexyl-N-methylamino)-3'-methylspiro(phthalido-3,9'-xanthene)-2'-ylamino]phenyl}propane.

9. The liquid composition according to Claim 1, wherein the developer is a bisphenol A type developer, a biphenol type developer, a bisphenol S type developer or a sulfonylphenol type developer.

10. The liquid composition according to Claim 1, wherein the developer is at least one member selected from the group consisting of 4,4'-isopropylidenediphenol, 1,1-bis(p-hydroxyphenyl)cyclohexane, 4,4'-dihydroxybiphenyl, 4,4'-sulfonyldiphenol, 2,2'-diallyl-4,4'-sulfonyldiphenol and 4-(4'-isopropoxyphenyl)-sulfonylphenol.

11. A laser marking article having a cured coating film of the liquid composition according to Claim 1 on its surface.

12. The laser marking article according to Claim 11, wherein the article is a bottle, a cap, a card, a label or a can.

13. The laser marking article according to Claim 11, wherein the material constituting the article is aluminum.

14. The laser marking article of Claim 11, wherein the thickness of the cured coating film is 3 to 50 µm.

15. A process for producing a laser marking article, which comprises coating an article with the liquid composition according to Claim 1 by a spray coating method and then irradiating the coated article with an energy beam except laser.

16. The process for producing the laser marking article according to Claim 15, wherein the energy beam is an ultraviolet ray or an electron beam.

17. A laser marking process which comprises irradiating a cured film layer formed on the surface of an article with a laser beam.

18. The laser marking process according to Claim 17, wherein the laser is an infrared ray laser.

19. The laser marking process according to Claim 18, wherein the infrared ray laser is a far infrared ray laser.

20. The laser marking process according to Claim 17, wherein the energy density in the portion irradiated with a laser beam is 0.5 to 6 J/cm².
